(19)

Europäisches
Patentamt
European
Patent Office
Office européen
des brevets

(11) **EP 2 482 340 A2**

(12) **EUROPEAN PATENT APPLICATION**

(43) Date of publication:
01.08.2012 Bulletin 2012/31

(51) Int Cl.:
*H01L 31/0687* (2012.01)    *H01L 31/0725* (2012.01)
*H01L 27/142* (2006.01)    *H01L 31/102* (2006.01)
*H01L 31/109* (2006.01)    *G02B 6/42* (2006.01)
*H01L 27/144* (2006.01)

(21) Application number: 12165821.5

(22) Date of filing: 03.08.2005

(84) Designated Contracting States:
AT BE BG CH CY CZ DE DK EE ES FI FR GB GR
HU IE IS IT LI LT LU LV MC NL PL PT RO SE SI
SK TR

(30) Priority: 09.09.2004 US 937807

(62) Document number(s) of the earlier application(s) in
accordance with Art. 76 EPC:
05778757.4 / 1 790 016

(71) Applicant: **The Boeing Company**
**Chicago, IL 60606-2016 (US)**

(72) Inventors:
• **Krut, Dimitri**
**Encino, CA California 91436 (US)**

• **Sudharsanan, Rengarajan**
**Stevenson Ranch, CA California 91381 (US)**
• **Karam, Nasser, H.**
**La Canada, CA California 91011 (US)**
• **King, Richard, R.**
**Thousand Oaks, CA California 91360-1925 (US)**

(74) Representative: **Penny, Daryl**
**Boult Wade Tennant**
**Verulam Gardens**
**70 Gray's Inn Road**
**London WC1X 8BT (GB)**

Remarks:
This application was filed on 26-04-2012 as a
divisional application to the application mentioned
under INID code 62.

(54) **Multijunction laser light detector with multiple voltage device implementation**

(57)    Laser power conversion with multiple stacked
junctions or subcells are disclosed to produce increased
output. Both vertical and horizontal integration are disclosed for flexible, efficient, and cost-effective laser pow-
er conversion. One embodiment of a laser power con-
verter includes at least a first or top subcell that receives
incident laser light, a second subcell below the first subcell that subsequently receives the laser light, and a tunnel junction between the first and second subcells.

FIG. 2

EP 2 482 340 A2

## Description

### TECHNICAL FIELD

The present invention relates generally to power conversion devices and, more particularly, to laser power converters.

### BACKGROUND

Laser power conversion devices can convert monochromatic illumination from a laser into current and voltage output. Applications for laser power converters have included powering of remote devices requiring a high degree of isolation, electrical noise immunity, intrinsic safety, low magnetic signature, and/or a compact and clean power source. Remote power applications can be found in the medical, aeronautical, and explosive detonation fields to name a few. Such a wide variety of applications leads to the need for a laser power converter that can accommodate various voltage and current output needs.

Irrespective of applications in terrestrial environments or in the non-terrestrial environment of outer space, efforts have been ongoing to also increase the output and/or efficiency of laser power conversion systems.

As a result, there is a need for an improved laser power converter that has increased efficiency and output, a flexible and scalable device structure applicable to a variety of voltage and current configurations, and is cost-effective in terms of material and manufacturing costs.

### SUMMARY

Apparatus, systems, and methods are disclosed herein to provide laser power conversion with multiple stacked junctions or subcells to produce increased output. Both vertical and horizontal integration are disclosed for flexible, efficient, and cost-effective laser power conversion. For example, in accordance with an embodiment of the present invention, a laser power converter comprises a first subcell that receives monochromatic illumination and produces a first current output, and a second subcell that receives a portion of the monochromatic illumination after the first subcell receives the monochromatic illumination, the second subcell producing a second current output that is substantially equal to the first current output. A tunnel junction is disposed between the first subcell and the second subcell.

In accordance with another embodiment of the present invention, a laser power converter with a multi-voltage implementation is provided, wherein the first and second subcells comprise a horizontally-integrated subcell, such that a first portion of the first and second subcells produces a different current and voltage output than a second portion of the first and second subcells.

In accordance with another embodiment of the present invention, a laser power conversion system is provided, comprising a laser source that provides monochromatic illumination, a laser power converter as previously described, and means for transmitting the monochromatic illumination to the laser power converter. In one example, the means for transmitting the monochromatic illumination is an optical fiber.

In accordance with another embodiment of the present invention, a method of converting laser power is provided, comprising converting monochromatic light to a first current output by transmission through a first subcell; transmitting a portion of the monochromatic light from the first subcell through a tunnel junction; and converting monochromatic light from the tunnel junction to a second current output by transmission through a second subcell, wherein the second current output is substantially equal to the first current output.

The scope of the invention is defined by the claims, which are incorporated into this section by reference. A more complete understanding of embodiments of the present invention will be afforded to those skilled in the art, as well as a realization of additional advantages thereof, by a consideration of the following detailed description of one or more embodiments. Reference will be made to the appended sheets of drawings that will first be described briefly.

The invention may be provided in accordance with the following numbered clauses:

1. A laser power converter, comprising: a first subcell that receives monochromatic illumination and produces a first current output; a second subcell that receives a portion of the monochromatic illumination after the first subcell receives the monochromatic illumination, the second subcell producing a second current output that is substantially equal to the first current output; and a tunnel junction disposed between the first subcell and the second subcell.

2. The laser power converter of clause 1, wherein the first subcell includes a base and an emitter.

3. The laser power converter of clause 2, wherein the base is comprised of GaAs and the emitter is comprised of InGaP.

4. The laser power converter of clause 1, wherein the first subcell produces between about 44% and about 49% of the total current produced by the first subcell and the second subcell.

5. The laser power converter of clause 1, wherein the first subcell has a thickness between about 5,000 Å and about 6,000 Å and the second subcell has a thickness between about 6,000 Å and about 30,000 Å.

6. The laser power converter of clause 1, wherein the first subcell and the second subcell is comprised of a material selected from the group consisting of GaAs, GaInPAs, GaInP, AlInGaP, InGaAs, GaSb, and $Al_xGa_{(1-x)}As$ where x is between about 3 mol percent and about 5 mol percent.

7. The laser power converter of clause 1, wherein the second subcell includes a base and an emitter.

8. The laser power converter of clause 1, wherein the first subcell and the second subcell have substantially equal bandgaps.

9. The laser power converter of clause 1, wherein the first subcell and the second subcell are comprised of dissimilar materials.

10. The laser power converter of clause 1, wherein the first subcell and the second subcell are comprised of the same material.

11. The laser power converter of clause 1, wherein the monochromatic illumination is provided by a laser.

12. The laser power converter of clause 1, wherein the monochromatic illumination is provided at a wavelength range selected from the group consisting of between about 810 nm and about 840 nm and between about 630 nm and about 670 nm.

13. The laser power converter of clause 1, wherein the monochromatic illumination is provided at a wavelength selected from the group consisting of about 980 nm, about 1310 nm, and about 1550 nm.

14. The laser power converter of clause 1, wherein the monochromatic illumination is provided via transmission means selected from the group consisting of an optic fiber and atmosphere.

15. The laser power converter of clause 1, wherein the tunnel junction has a thickness between about 100 Å and about 1,000 Å.

16. The laser power converter of clause 1, wherein the tunnel junction is comprised of a material selected from the group consisting of InGaP and AlGaAs.

17. The laser power converter of clause 1, further comprising a semi-insulating substrate, wherein the second subcell is located between the substrate and the tunnel junction.

18. The laser power converter of clause 17, wherein the semi-insulating substrate is comprised of a material selected from the group consisting of GaAs, Ge, and InP.

19. The laser power converter of clause 1, further comprising a third subcell adjacent the second subcell and a second tunnel junction disposed between the second subcell and the third subcell.

20. The laser power converter of clause 19, wherein the first subcell has a thickness between about 1,000 Å and about 3,000 Å, the second subcell has a thickness between about 1,000 Å and about 3,000 Å, and the third subcell has a thickness greater than 30,000 Å.

21. The laser power converter of clause 20, wherein the first and second and third subcells are comprised of a material selected from the group consisting of GaAs, GaInPAs, GaInP, AlInGaP, InGaAs, GaSb, and $Al_xGa_{(1-x)}As$ where x is between 0 mol percent and about 5 mol percent.

22. The laser power converter of clause 1, further comprising a plurality of subcells adjacent the second subcell and a plurality of tunnel junctions disposed between the plurality of subcells.

23. The laser power converter of clause 1, further comprising a plurality of horizontally-integrated subcells of the first and second subcells, the plurality of horizontally-integrated subcells electrically coupled in series.

24. The laser power converter of clause 1, wherein the first subcell comprises a first portion and a second portion, the first portion producing a different current output than the second portion.

25. The laser power converter of clause 1, wherein the first subcell comprises a first portion and a second portion, the first portion producing a different voltage output than the second portion.

26. A laser power converter with multi-voltage implementation, comprising: a first subcell that receives monochromatic illumination and produces a first current output; a second subcell that receives a portion of the monochromatic illumination after the first subcell receives the monochromatic illumination, the second subcell producing a second current output that is substantially equal to the first current output; a tunnel junction disposed between the first subcell and the second subcell; wherein the first and second subcells comprise a horizontally-integrated subcell, such that a first portion of the first and second subcells produces a different current and voltage output than a second portion of the first and second subcells.

27. The laser power converter of clause 26, wherein the first portion produces a lower current and a higher voltage output than the second portion.

28. The laser power converter of clause 26, wherein the first portion is a central circular section and the second portion is a periphery section that includes multiple smaller sections that are series interconnected, the first portion producing a higher current than the second portion and the second portion producing higher voltage at lower current than the first portion.

29. A laser power conversion system, comprising: a laser source that provides monochromatic illumination; means for transmitting the monochromatic illumination to a laser power converter, the laser power converter including: a first subcell that receives the monochromatic illumination from the laser source via the means for transmitting and produces a first current output; a second subcell that receives a portion of the monochromatic illumination after the first subcell receives the monochromatic illumination, the second subcell producing a second current output that is substantially equal to the first current output; and a tunnel junction disposed between the first subcell and the second subcell.

30. The system of clause 29, wherein the means for transmitting is selected from the group consisting of optical fiber and atmosphere.

31. A method of converting laser power, the method comprising: converting monochromatic light to a first current output by transmission through a first subcell; transmitting a portion of the monochromatic light from the first subcell through a tunnel junction; and converting monochromatic light from the tunnel junction to a second current output by transmission through a second subcell, wherein the second current output is substantially equal to the first current output.

32. The method of clause 31, further comprising providing a horizontally-integrated subcell of the first subcell, such that a first portion of the first subcell produces a different current and voltage output than a second portion of the first subcell.

33. The method of clause 32, wherein the first portion produces a lower current and a higher voltage output than the second portion.

34. The method of clause 31, further comprising providing a plurality of horizontally-integrated subcells of the first and second subcells, the plurality of horizontally-integrated subcells electrically coupled in series.

35. A laser power converter, comprising: a central light collection and electrical conversion region that produces high current; a plurality of sections along a periphery of the central light collection and electrical conversion region, the plurality of sections interconnected in series; and independent contacts to the central light collection and electrical conversion region and the plurality of sections along the periphery.

36. The laser power converter of clause 35, wherein the central light collection and electrical conversion region and the plurality of sections are each formed of at least two subcells with a tunnel junction interposed therebetween.

## BRIEF DESCRIPTION OF THE DRAWINGS

Fig. 1 shows a laser power conversion system in accordance with an embodiment of the present invention.

Fig. 2 shows a diagram illustrating a two-junction laser power converter in accordance with an embodiment of the present invention.

Fig. 3 shows a graph illustrating current generation as a function of a gallium arsenide (GaAs) top subcell thickness in a two-junction laser power converter.

Fig. 4 shows a diagram illustrating a three-junction laser power converter in accordance with another embodiment of the present invention.

Fig. 5 shows a diagram illustrating a multijunction laser power converter with horizontally-integrated sections in accordance with another embodiment of the present invention.

Figs. 6 and 7 show different multijunction laser power converters with horizontally-integrated sections capable of providing multiple volts and currents in accordance with another embodiment of the present invention.

Fig. 8 shows a diagram illustrating a two-junction laser power converter including a heterojunction emitter for the top subcell in accordance with another embodiment of the present invention.

It should be appreciated that like reference numerals are used to identify like elements illustrated in one or more of the figures. Furthermore, the figures are not necessarily drawn to scale. Embodiments of the present invention and their advantages are best understood by referring to the detailed description that follows.

## DETAILED DESCRIPTION

The present invention provides for multijunction formation of similar or dissimilar materials with substantially equal bandgap to divide incoming monochromatic light by absorption in each junction of a laser power converter. In general, the laser power converter of the present invention includes at least a first or top subcell (used interchangeably with "junction" throughout) that receives incident laser light, a second subcell below the first subcell that subsequently receives the laser light, and a tunnel junction between the first and second subcells. Two and three-junction designs are disclosed but more junctions are within the scope of the present invention. In such instance, tunnel junctions are placed between each of the plurality of subcells.

In a multiple subcell device, semiconductor materials may be lattice-matched to form multiple p-n (or n-p) junctions. The p-n (or n-p) junctions can be of the homojunction or heterojunction type. When laser energy is received at a junction, minority carriers (i.e., electrons and holes) are generated in the conduction and valence bands of the semiconductor materials adjacent the junction. A voltage is thereby created across the junction and a current can be utilized therefrom. As non-absorbed (and non-converted) laser energy passes to the next junction for conversion into voltage and current, greater overall conversion efficiency and increased output voltage is gained.

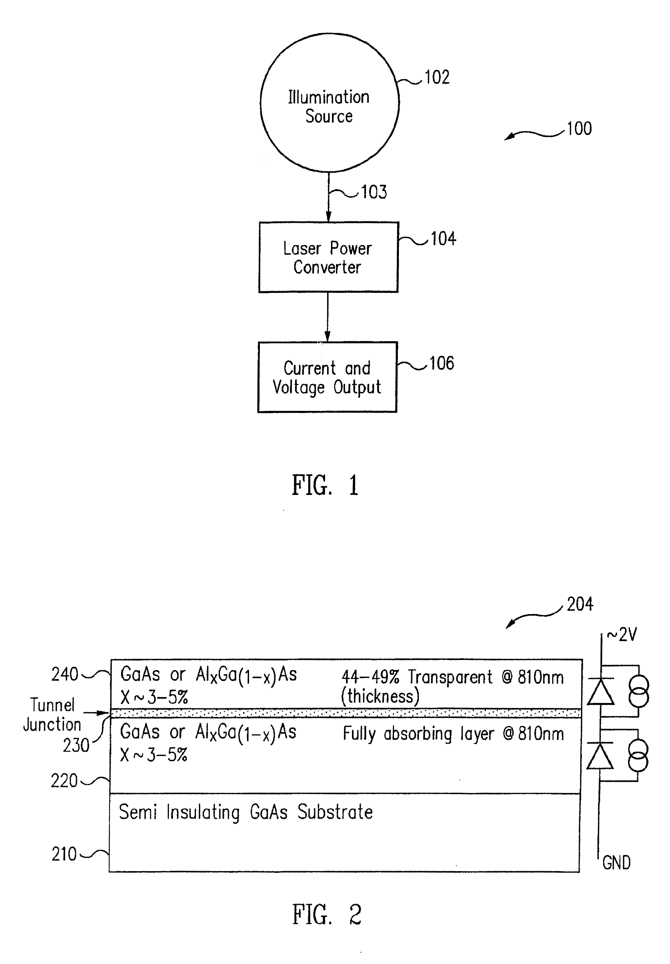

Fig. 1 shows a laser power conversion system 100 in accordance with an embodiment of the present invention. System 100 includes a source of monochromatic illumination 102, in one example a laser source consisting of a GaAs or similar laser diode, and transmission means 103 for transmitting the monochromatic illumination to a laser power converter 104, in one example an optic fiber. Current and voltage 106 are then output from the laser power converter 104.

Fig. 2 shows a diagram illustrating a two-junction laser power converter 204 in accordance with an embodiment of the present invention. Laser power converter 204 includes an optically thick bottom junction or subcell 220 formed over a substrate 210 comprised of semi-insulating material such as GaAs or germanium (Ge) in one example, following the formation of a nucleation layer and a buffer (both not shown). A thin and low-absorption interconnecting tunnel junction 230 is then formed over subcell 220. Typically, tunnel junctions include a thin layer of one to a few hundred Angstroms of highly doped semiconductor materials, preferably of higher bandgap energy than the laser light incident on the converter. A finely tuned, thickness-controlled second junction or subcell 240 is then formed over tunnel junction 230 to form a two-junction stack.

The two-junction design of laser power converter 204 with materials selected from, in one example, GaAs and/or aluminum gallium arsenide ($Al_xGa_{(1-x)}$As where x is between about 3 mol percent and about 5 mol percent), will yield about two volts output under monochromatic illumination at a wavelength between about 810 nm and about 840 nm. The first and second junctions may be of the same material systems, although the present invention contemplates that the materials of the junctions can be different.

Bottom subcell 220 is formed to be fully absorbing of the remainder of the monochromatic light received through the top subcell and in one example has a thickness between about 5,400 Å and about 30,000 Å, preferably between about 20,000 Å and about 30,000 Å.

In a multijunction stack, electrical connection must be made between the subcells. Preferably, these contacts should cause very low loss of electrical power between subcells and thus should have minimal electrical resistance. Tunnel junctions should have low resistivity, low optical energy losses, and crystallographic compatibility between top and bottom subcells. Tunnel junction 230 is preferably formed of the higher bandgap materials to minimize laser light absorption. An example of higher bandgap materials for the tunnel junction includes but is not limited to indium gallium phosphate (InGaP) and AlGaAs for the GaAs device implementation. The tunnel junction 230 may be constructed according to well known designs in the solar cell art, such as that shown in U.S. Patent No. 5,407,491, which is incorporated by reference herein for all purposes.

The thickness of subcell 240 is controlled to achieve current matching conditions with bottom subcell 220 for optimum efficiency in the series-connected configuration. A simple estimate of the thickness of the top subcell can be achieved from the following formula:

```
Target Thickness = ln(0.5) / Abs. Coefficient at wavelength
```

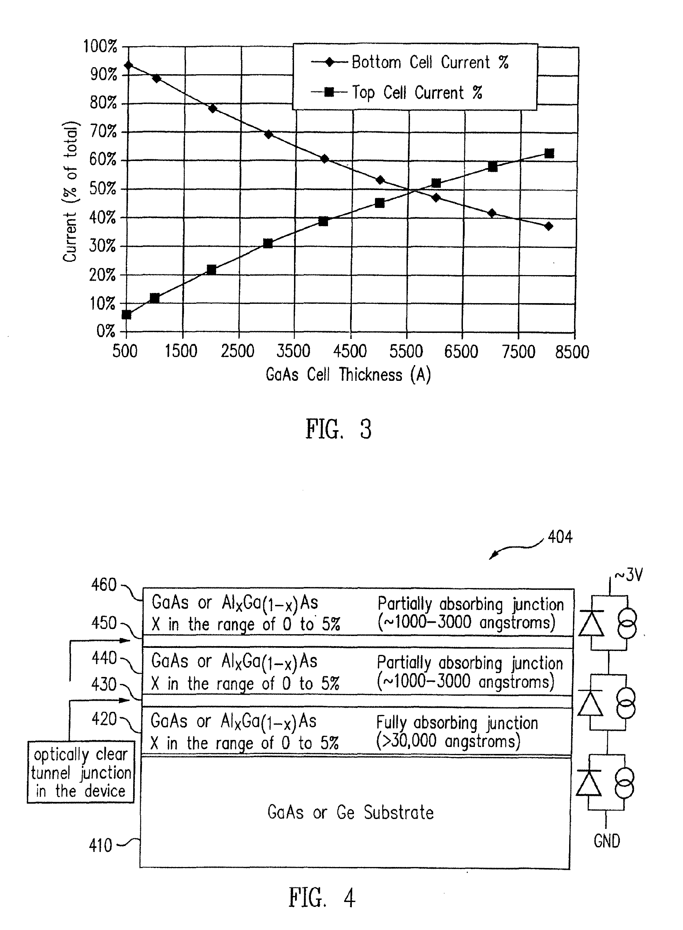

Modeling calculations based on the available material properties, such as absorption coefficients and basic device properties of GaAs diodes are summarized in Fig. 3. This graph illustrates current generation as a function of the top subcell thickness in the two-junction laser power converter of Fig. 2 based upon modeling calculations. Modeling calculations based on other semiconductor materials chosen for the implementation is also within the scope of the present invention.

The modeling calculations did not consider absorption losses in the tunnel junction between two subcells. To accommodate optical losses in the tunnel junction and other layers between subcells, the thickness of top subcell 240 will need to be adjusted so that top subcell 240 generates between about 44% and about 48% of the total current. Accordingly, the thickness of top subcell 240 is calculated to be maintained at between about 5,400 Å and about 5,600 Å, preferably at about 5,500 Å, in this embodiment. However, the thickness of the top cell may vary depending on the choice of the laser and a choice of the semiconductor material.

While not shown in the figures, each subcell 220 and 240 includes a base and an emitter, similar to those used in solar cells as shown, for example, in U.S. Patent No. 5,800,630, which is incorporated herein by reference for all purposes. Optionally, each subcell 220 and 240 may include a window layer and/or a back surface field layer, as is also known in the solar cell art and shown for example, in U.S. Patent No. 5,407,491, which is incorporated herein by reference for all purposes. The described thicknesses and compositions for the subcells refer to the main absorbing layers in each subcell, in other words the base and emitter layers for a homojunction subcell or to the base only for a heterojunction emitter subcell.

Subcells 220 and 240 have substantially equal bandgaps, in one example between about 1.39 eV and about 1.45 eV. In one embodiment, both subcells also have substantially the same lattice constant. This avoids the formation of defects in the crystal structures, which can drastically lower the efficiency of the devices. When the term lattice-matched is used herein, it denotes a difference in lattice constants between the materials of not more than about 0.3 percent.

The different semiconductor layers that form the laser power converter of the present invention (e.g., substrate 210, bottom subcell 220, tunnel junction 230, and top subcell 240) may be formed by various well known techniques in the art such as metal-organic vapor phase epitaxy (MOVPE), liquid phase epitaxy (LPE), metal-organic chemical vapor deposition (MOCVD), molecular beam epitaxy (MBE), metal-organic molecular beam epitaxy (MOMBE), and gas-source molecular beam epitaxy (GSMBE). In accordance with such methods, the specific materials comprising the semiconductor layers may be altered and optimized to meet the requirements of the particular context.

Laser power converter 204 can receive incident light that passes through an antireflection (AR) layer or coating (not shown) that is disposed over the topography of the converter 204. The antireflection layer is intended to minimize surface reflections between the optically transparent media above the converter (such as air, glass, or polymer) and the semiconductor layers of the converter 204, thereby enabling more photons to enter the converter. The antireflection coating can consist of a single layer or multiple layers and can be made from well-known materials, such as $TiO_2$, $Ta_2O_5$, $SiO_2$, and $MgF_2$. The thickness of the antireflective coating layers can vary, being in one example between about 500 Angstroms and about 1200 Angstroms.

Fig. 4 shows a diagram illustrating a three-junction laser power converter 404 in accordance with another embodiment of the present invention. The layers of laser power converter 404 are similar to the two-junction laser power converter 204 described above with respect to Figs. 2 and 3. However, laser power converter 404 includes three junctions or subcells 420, 440, and 460 with tunnel junctions 430 and 450 disposed between subcells 420 and 440 and between subcells 440 and 460, respectively. The stack of subcells and tunnel junctions are formed over a substrate 410.

Similar to laser power converter 204 described above, the substrate 410, subcells 420, 440, and 460, and tunnel junctions 430 and 450 may all be deposited by various well known techniques in the art such as metal-organic vapor phase epitaxy (MOVPE), liquid phase epitaxy (LPE), metal-organic chemical vapor deposition (MOCVD), molecular beam epitaxy (MBE), metal-organic molecular beam epitaxy (MOMBE), and gas-source molecular beam epitaxy (GSMBE).

In one example, GaAs and/or $Al_xGa_{(1-x)}As$ (where x is between 0 mol percent and about 5 mol percent) materials may again be used in the junctions to yield about three volts output under monochromatic illumination in a range between about 810 nm and about 840 nm. Ge can again be used in substrate 410.

The thickness of subcells 420, 440, and 460 are also controlled to achieve current matching conditions with one another. Accordingly, the thickness of subcell 460 is maintained at between about 1,000 Å and about 3,000 Å in this embodiment. Subcell 440 is also maintained at between about 1,000 Å and about 3,000 Å in this embodiment. Subcell 420 is formed to be fully absorbing of the remainder of the monochromatic illumination and is formed to have a thickness greater than about 30,000 Å in this embodiment.

Tunnel junctions of the higher bandgap materials are again preferably used to minimize laser light absorption. An example of higher bandgap materials for the tunnel junction includes but is not limited to indium gallium phosphate (InGaP) and AlGaAs for the GaAs device implementation.

Although certain materials, wavelengths, and layer thicknesses have been described in the above embodiments, the present invention is not so limited. Other materials, wavelengths, and layer thicknesses may be utilized based upon design and application specifications. Table 1 below lists other materials and wavelengths which may be used for the junctions, substrate, and laser illumination.

Table 1

| Laser Wavelength (nm) | Junction Material | Substrate Material |
| --- | --- | --- |
| 810-840 | GaAs, AlGaAs, GaInAsP | GaAs, Ge |
| 630-670 | GaInP, GaAs, AlInGaP | GaAs, Ge |
| 980 | InGaAs | GaAs, Ge, InP |
| 1310 | InGaAs | InP |
| 1550 | InGaAs, AlInGaAs, GaSb | InP |

As can be seen, preferred semiconductors utilized in the subcells include Group III-V composite materials, such as GaAs and AlGaAs. Other absorbing junction materials such as gallium indium arsenide phosphate (GaInAsP), aluminum indium gallium phosphate (AlInGaP), indium gallium arsenide (InGaAs), aluminum indium gallium arsenide (AlInGaAs), and gallium antimony (GaSb) may be used. Advantageously, utilizing junctions formed of semiconductors with higher bandgaps allows for increased voltage output while lowering the absorption coefficient, for example in the 810-840 nm wavelength range in the upper junctions. Lower absorption permits the growing of thicker upper junctions, thus easing manufacturing parameters, for example when implementing MOVPE growth of layers.

Ge can be advantageously used in substrate 210. Ge is less costly, more robust, and easier to process than GaAs. As Ge has better thermal transfer properties than GaAs and is usually thinner than GaAs substrates of equivalent area, better device cooling is anticipated.

Metamorphic materials that do not match the lattice constant of the substrate may also be used to accommodate even a wider range of possible laser wavelengths in accordance with another embodiment of the present invention. In one example, a laser wavelength of 980 nm may be accommodated by a metamorphic $In_xGa_{(1-x)}As$ device built on the GaAs or Ge substrates, where the In composition is in the range of about 15 mol percent to about 23 mol percent.

Furthermore, horizontal integration in which structures are processed using a number of photolithographic and metallization steps to produce monolithic devices with a number of sections in the same plane (typically of radial geometry) is also possible. Thus, the multijunction nature of the present invention allows for the formation of higher voltage devices with fewer horizontal sections or segments than is possible using a single junction method. Accordingly, both vertical and horizontal integration allows for the simplification of device fabrication processes and more active area may be maintained without the loss associated with vertical etching during electrical isolation of active planar segments.

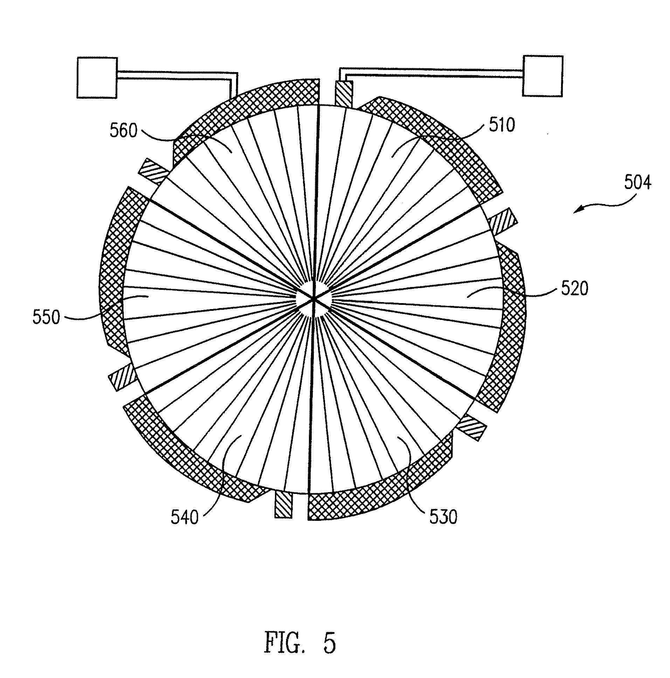

Fig. 5 shows a diagram illustrating a multijunction laser power converter with horizontally-integrated sections or segments in accordance with another embodiment of the present invention. To achieve higher voltage and other possible voltage configurations, individual sections of the laser power converter can be electrically isolated on a horizontal level and then interconnected. For example, six two-junction GaAs devices will generate about 12 volts, while thin GaInPAs/thick GaInPAs subcells interconnected in series will generate between about 13 volts and about 14 volts. If a three-junction configuration is used for horizontal integration on a semi-insulating substrate, a 12-14 volts device can be constructed with four three-junction devices connected in series, for example made up of GaAs, AlGaAs, and GaInPAs junctions.

Accordingly, Fig. 5 illustrates a laser power converter 504 with six horizontally-integrated sections 510, 520, 530, 540, 550, and 560. When laser power converter 504 includes two junctions, it may output between about 12 volts and about 14 volts. When laser power converter 504 includes three junctions, it may output between about 18 volts and about 20 volts.

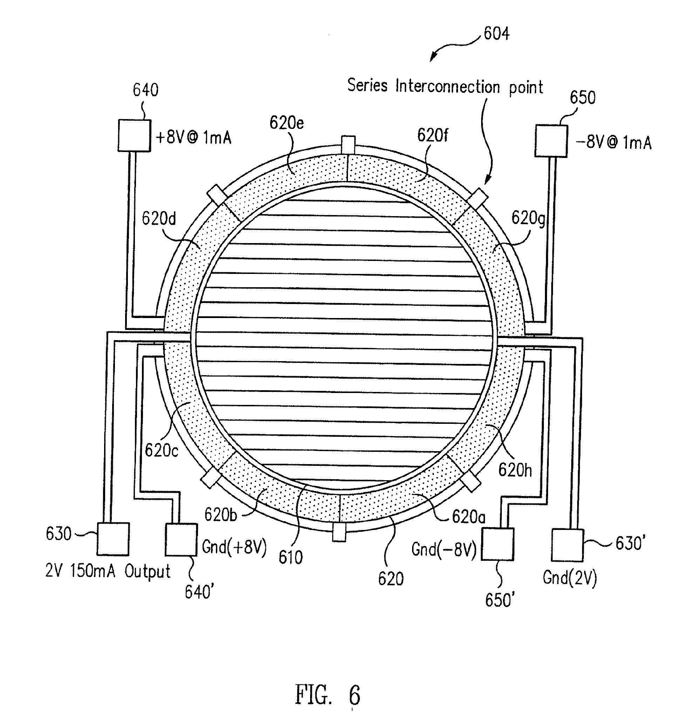

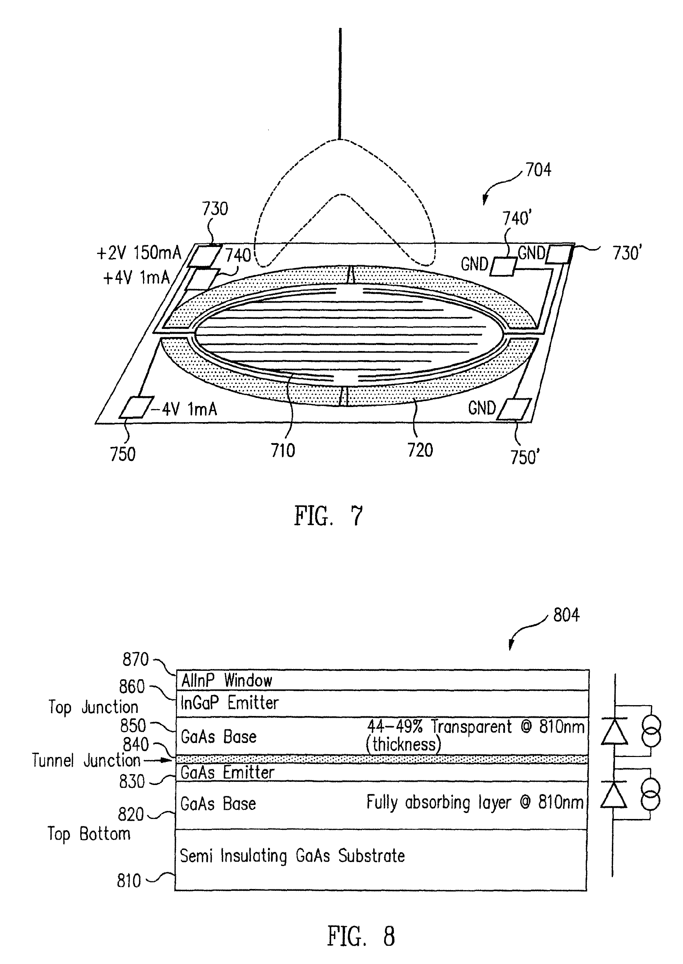

Figs. 6 and 7 show different embodiments of a multijunction laser power converter with horizontally-integrated sections capable of providing multiple voltages and currents. Both positive and negative higher voltage sections as well as lower voltage/higher current sections are possible to accommodate split voltage and/or unbalanced current requirements.

Referring now to Fig. 6, interior section 610 of laser power converter 604 will receive the predominant amount of the incident light, and approximately 2 volts may be produced in a two-junction implementation of laser power converter 604, as indicated by electrodes 630 and 630'. Outer section 620 integrated as an outer ring will receive less incident light, and thus will produce less current. However, outer section 620 may be subdivided into smaller, monolithically integrated sections to produce higher voltages and even bipolar implementations. For example, the outer section 620 may be configured to produce high voltage and low current output while the inner section produces low voltage (e.g., about 2 volts) and high current output (e.g., about 150 mA). The outer section may also be configured either as a bipolar voltage supply or as a single-polarity device with even higher voltage. As can be seen in Fig. 6, outer section 620 is configured into eight sections 620a-620h to form a bipolar voltage supply, thus producing +8 volts at 1 mA and -8 volts at 1 mA as shown by electrodes 640, 640' and 650, 650', respectively.

Referring now to the multi-voltage embodiment illustrated in Fig. 7, laser power converter 704 is similar to the laser power converter 604 illustrated in Fig. 6. Interior section 710 of the active area will receive the predominant amount of the incident light, and approximately 2 volts may be produced in a two-junction implementation of laser power converter 604, as indicated by electrodes 730 and 730'. Outer section 720 is also integrated as an outer ring and will receive less incident light, and thus will produce less current. Outer section 720 may be subdivided into smaller, monolithically integrated sections to produce higher voltages and even bipolar implementations. For example, the outer section 720 is configured into four sections and a bipolar voltage supply, thus producing +4 volts at 1 mA and -4 volts at 1 mA as shown by electrodes 740, 740' and 750, 750', respectively. In one example, a gaussian cone of light emitted from a fiber 760 is shown in Figure 7 by a dashed line connected to a vertical line (i.e., the optical fiber).

The formation of the multivoltage implementation of the laser power converter is performed using standard photolitographical techniques employed in the semiconductor industry. One possible implementation sequence may include an isolation trough formation by a chemical etching step. Such a process may define the central circular section (e.g., interior sections 610 and 710), along with the smaller sections around the periphery (e.g., outer sections 620 and 720). The second step can involve metal formation on the surface. Depending on the choice of materials this step may include one or more steps to deposit N-type contacts and P-type contacts. An AR coating step can follow.

Fig. 8 shows a diagram illustrating a two-junction laser power converter including a heterojunction emitter for the top subcell in accordance with another embodiment of the present invention. Similar to the embodiment disclosed above with respect to Figs. 2 and 3, a two-junction laser power converter 804 includes a substrate 810 and a bottom junction including a GaAs base layer 820 and a GaAs emitter layer 830. A tunnel junction 840 is formed over emitter layer 830.

In this embodiment, however, a GaAs emitter of the top junction is replaced with a higher bandgap material, such as an InGaP emitter 860 over a GaAs base 850. The high bandgap, heterojunction emitter would be optically transparent to the laser light and thus, emitter 860 may be fabricated thicker than with lower bandgap material, thereby reducing sheet resistivity and improving device performance due to lower sheet resistance losses and lower obscuration of the grid lines. Another advantage is that the base of the top junction can be grown thicker than otherwise, thereby improving electronic properties and manufacturing considerations. A similar heterojunction emitter can be implemented in a three-junction configuration, providing a benefit especially for the top two junctions.

Embodiments described above illustrate but do not limit the invention. While the present invention may be particularly useful in the context of spacecraft, other applications and contexts, such as sensors and other optoelectronic devices, are contemplated to be within the scope of the present invention. It should also be understood that numerous modifications and variations are possible in accordance with the principles of the present invention. Accordingly, the scope of the invention is defined only by the following claims.

**Claims**

1. A laser power converter with multi-voltage implementation, comprising:

   a first subcell that receives monochromatic illumination and produces a first current output;
   a second subcell that receives a portion of the monochromatic illumination after the first subcell receives the monochromatic illumination, the second subcell producing a second current output that is substantially equal to the first current output;
   a tunnel junction disposed between the first subcell and the second subcell;
   wherein the first and second subcells comprise a horizontally-integrated subcell comprising a first portion of the first and second subcells and a second portion of the first and second subcells, such that a first portion of the first and second subcells produces a different current and voltage output than a second portion of the first and second subcells.

2. The laser power converter of Claim 1, wherein the first portion produces a lower current and a higher voltage output than the second portion.

3. The laser power converter of Claim 1, wherein the first portion is a central circular section and the second portion is a periphery section that includes multiple smaller sections that are series interconnected, the first portion producing a higher current than the second portion and the second portion producing higher voltage at lower current than the first portion.

4. The laser power converter of claim 1,
   wherein the first portion comprises a central light collection and electrical conversion region that produces high current; and
   the second portion comprises a plurality of sections along a periphery of the central light collection and electrical conversion region, the plurality of sections interconnected in series;
   the laser power converter comprising independent contacts to the central light collection and electrical conversion region and the plurality of sections along the periphery.

5. The laser power converter of Claim 4, wherein the central light collection and electrical conversion region and the plurality of sections are each formed of at least two subcells with a tunnel junction interposed therebetween.

6. The laser power converter of any of claims 1 to 5, further comprising a third subcell adjacent the second subcell and a second tunnel junction disposed between the second subcell and the third subcell.

7. A method of converting laser power, the method comprising:

   converting monochromatic light to a first current output by transmission through a first subcell;
   transmitting a portion of the monochromatic light from the first subcell through a tunnel junction;
   converting monochromatic light from the tunnel junction to a second current output by transmission through a second subcell, wherein the second current output is substantially equal to the first current output; and
   providing a horizontally-integrated subcell of the first subcell, such that a first portion of the first subcell produces a different current and voltage output than a second portion of the first subcell.

8. The method of Claim 7, wherein the first portion produces a lower current and a higher voltage output than the second portion.

9. The method of Claim 7, further comprising providing a plurality of horizontally-integrated subcells of the first and second subcells, the plurality of horizontally-integrated subcells electrically coupled in series.

FIG. 1

FIG. 2

FIG. 3

FIG. 4

FIG. 5

604

Series Interconnection point

640

+8V @ 1mA

620e

620f

650

−8V @ 1mA

620d

620g

620c

620h

630

2V 150mA Output

Gnd(+8V)

620b

610

620a

Gnd(−8V)

620

630'

Gnd(2V)

640'

650'

FIG. 6

+2V 150mA
+4V 1mA

730  740  704  740'  730'

GND  GND

-4V 1mA

GND

750  710  720  750'

FIG. 7

804

870 — AlInP Window
860 —
Top Junction  InGaP Emitter
850 —  GaAs Base  44–49% Transparent @ 810nm (thickness)
840 —
Tunnel Junction →  GaAs Emitter
830 —
 GaAs Base  Fully absorbing layer @ 810nm
820 —
Top Bottom
 Semi Insulating GaAs Substrate
810 —

FIG. 8

**REFERENCES CITED IN THE DESCRIPTION**

**Patent documents cited in the description**

- US 5407491 A

- US 5800630 A